Europäisches Patentamt

European Patent Office

Office européen des brevets

(10)

(11) Publication number: **0 068 894**
**B1**

(12) **EUROPEAN PATENT SPECIFICATION**

(45) Date of publication of patent specification: **13.12.89**

(51) Int. Cl.⁴: **G 11 C 11/24**

(21) Application number: **82303414.5**

(22) Date of filing: **29.06.82**

(54) **Dynamic random access memory device.**

(30) Priority: **29.06.81 JP 99753/81**
**30.09.81 JP 155098/81**

(43) Date of publication of application:
**05.01.83 Bulletin 83/01**

(45) Publication of the grant of the patent:
**13.12.89 Bulletin 89/50**

(84) Designated Contracting States:
**DE FR GB NL**

(56) References cited:
**EP-A-0 023 329**
**US-A-4 156 939**
**US-A-4 239 993**

**IEEE JOURNAL OF SOLID-STATE CIRCUITS,
vol.CS-15, no. 2, April 1980, pages 184-189, IEEE,
New York, US; F.J. SMITH et al.: "A 64 kbit MOS
dynamic RAM with novel memory capacitor"**

**PATENTS ABSTRACTS OF JAPAN, vol. 4, no.
100 (P-19)582r, 18th July 1980; & 55 58890
(HITACHI SIESAKUSHO K.K.) 01-05-1980**

(73) Proprietor: **FUJITSU LIMITED**
**1015, Kamikodanaka Nakahara-ku**
**Kawasaki-shi Kanagawa 211 (JP)**

(72) Inventor: **Nakano, Tomio**
**12-404, 1-11-2, SHirahatadai Takatsu-ku**
**Kawasaki-shi Kanagawa 213 (JP)**
Inventor: **Nakano, Masao**
**473-4, Hisasue Takatsu-ku**
**Kawasaki-shi Kanagawa 213 (JP)**
Inventor: **Takemae, Yoshihiro**
**5-9-301, 1-20, Utsukushigaoka Midori-ku**
**Yokohama-shi Kanagawa 227 (JP)**
Inventor: **Tsuge, Norihisa**
**6-14, Zaimokuza 5-chome**
**Kamakura-shi Kanagawa 248 (JP)**
Inventor: **Ohira, Tsuyoshi**
**Fujitsu dai-2 Edaryo 440-1, Eda-cho Midori-ku**
**Yokohama-shi Kanagawa 227 (JP)**

(74) Representative: **Fane, Christopher Robin King
et al**
**HASELTINE LAKE & CO. Hazlitt House**
**28 Southampton Buildings, Chancery Lane**
**London, WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a semiconductor device, more particularly, to a dynamic random access memory (RAM) device comprising one-transistor, one-capacitor-type memory cells.

In a MOS dynamic RAM device, one-transistor, one-capacitor-type memory cells have been put to practical use, and, in addition, such memory cells are often used since they are advantageous in respect to integration density. In this type of memory cell, each cell comprises a capacitor and a transistor which serves as a switching element for charging and discharging the capacitor. Therefore, the presence or absence of charges in the capacitor represents data "1" or "0". The memory cells are arranged at intersections between word lines and bit lines. In addition, dummy cells are arranged at intersections between dummy word lines and bit lines.

In the prior art, these dummy cells are similar in construction to the one-transistor, one-capacitor-type memory cells in that they comprise a capacitor, a transistor, and an additional transistor for resetting the capacitor. However, in recent years, dummy cells comprising only one capacitor have been developed (See: IEEE Journal of Solid-State Circuits, vol. SC-15, No. 2, pp. 184—189, Apr. 1980). A dynamic RAM including such one-capacitor dummy cells is advantageous in respect to integration density and reduces the load of the operation clock generator.

In a dynamic RAM device including the above-mentioned one-capacitor-type dummy cells, a discharging transistor and a charging transistor are provided in series between two power supplies ($V_{CC}$, $V_{SS}$), and their connection node is connected to a dummy word line connected to the dummy cells. The control of this device is carried out as follows. First, the dummy word line is discharged by the discharging transistor clocked by a reset clock generator. In this state, the dummy word line is at level $V_{SS}$. Then, the dummy word line is charged by the charging transistor clocked by an operation clock generator so that the potential of the dummy word line is pushed up to the power supply voltage ($V_{CC}$).

In the above-mentioned dynamic RAM device, however, in order to push up the potential of the dummy word line, the operation clock generator must generate a potential higher than $V_{CC}+V_{th}$, where $V_{th}$ is the threshold voltage value of the charging transistor. As a result, the operation clock generator has to incorporate a charge-pumping circuit or a bootstrap circuit for generating such a higher potential. Therefore, the operation clock generator becomes complex, and accordingly, the operation speed of the operation clock generator, that is, the access speed of the device, becomes low.

The abstract of JP—A—5 558 890 in Patents Abstracts of Japan, Vol. 4 No. 100 (P-19), (582) discloses a reference voltage generation circuit for a dynamic RAM which is simplified by applying a timing pulse in opposite phase with a word selection signal to the capacitance of a dummy cell producing a reference voltage. Various timing signals and pulses involved in a memory cell read operation are mentioned; however, the above-mentioned problem of the prior art is not mentioned.

According to the present invention, there is provided a dynamic random access memory device comprising:

first and second power supplies, the potential of said first power supply being lower than that of said second power supply;

a plurality of word lines selectively driven by a first clock signal;

a plurality of pairs of bit lines precharged by said second power supply in response to a third clock signal;

a plurality of sense amplifiers, each sense amplifier being arranged between one pair of said pairs of bit lines, for sensing the difference in potential between said pairs of bit lines;

a plurality of one-transistor, one-capacitor-type memory cells in rows and columns, each memory cell being connected to one of said word lines and to one of said bit lines;

a plurality of dummy cells, each dummy cell comprising a capacitor and a connection node, said capacitor having an electrode connected on one of said bit lines and another electrode connected to one of said connection nodes; characterised by

a first clock generator for generating said first clock signal with a potential higher than the potential of the second power supply and a second clock signal with a potential lower than or equal to the potential of said second power supply;

a second clock generator for generating said third clock signal with a potential higher than the potential of said second power supply alternately with the first and second clock signals;

charging means comprising a plurality of transistors, each transistor being incorporated into one of said dummy cells and having a drain connected to one of said respective bit line, a source connected to one of said connection nodes of said dummy cells, and a gate for receiving said third clock signal so as to be driven thereby to charge the connection nodes of each of said dummy cells to the potential of said second power supply; and

at least one discharging means comprising at least one transistor, each discharging means being connected to each of said connection nodes of said dummy cells respectively and driven by said second clock signal, for discharging the connection nodes of each of said dummy cells to the potential of said first power supply.

An embodiment of the present invention may provide a dynamic RAM device comprising one-transistor, one-capacitor-type memory cells in which the access speed is high.

An embodiment of the present invention may also provide a dynamic RAM device comprising one-transistor, one-capacitor-type memory cells in which correct data can be read out even if the fluctuation of a power supply voltage is generated.

Reference is made, by way of example, to the accompanying drawings, wherein:

Figure 1 is a block circuit diagram illustrating a prior art dynamic RAM device;

Fig. 2 is a partial circuit diagram of the circuit of Fig. 1;

Figure 3 is a circuit diagram illustrating another prior art dynamic RAM device;

Figs. 4A and 4B are timing diagrams of the signals appearing in the circuit of Fig. 3;

Fig. 5 is a circuit diagram illustrating a first type of dynamic RAM device for explaining the present invention;

Figs. 6A and 6B are timing diagrams of the signals appearing in the circuit of Fig. 5;

Fig. 7 is a circuit diagram illustrating a second type of dynamic RAM device for explaining the present invention;

Figs. 8A and 8B are also timing diagrams of the signals appearing in the circuit of Fig. 5; and

Fig. 9 is a circuit diagram illustrating an embodiment of the dynamic RAM device according to the present invention.

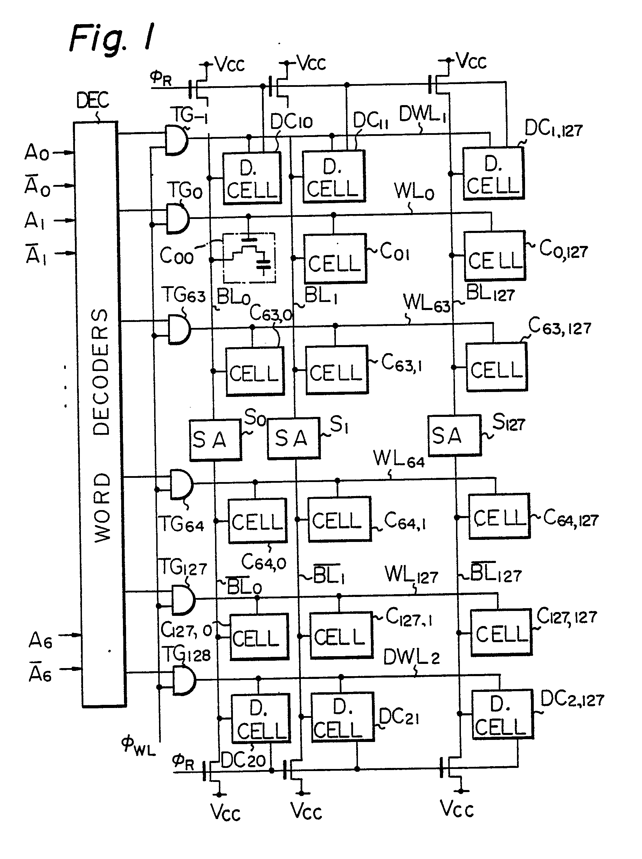

First, the prior art dynamic RAM devices will be explained with reference to Figs. 1, 2, 3, 4A, and 4B. In Fig. 1, for example, a 16 kbit (precisely, 16,384 bit) RAM device is illustrated. In the figure, one-transistor, one-capacitor-type memory cells $C_{00}$, $C_{01}$, ..., $C_{0,127}$, $C_{63,0}$, $C_{63,1}$, ..., $C_{63,127}$, $C_{64,0}$, $C_{64,1}$, ..., $C_{64,127}$, $C_{127,0}$, $C_{127,1}$, ..., and $C_{127,127}$ in rows and columns are arranged at intersections between word lines $WL_0$, ... $WL_{63}$, $WL_{64}$, ..., and $WL_{127}$ and bit lines $BL_0$, $\overline{BL_0}$, $BL_1$, $\overline{BL_1}$, ..., $BL_{127}$, and $\overline{BL_{127}}$, and sense amplifiers $S_0$, $S_1$, ..., and $S_{127}$ in a row are arranged between bit line pairs $BL_0$, $\overline{BL_0}$, $BL_1$, $\overline{BL_1}$, ..., $BL_{127}$, and $\overline{BL_{127}}$. Further, dummy cells $DC_{10}$, $DC_{11}$, ..., and $DC_{1,127}$ in a row are connected to the terminals of bit lines $BL_0$, $BL_1$, ..., and $BL_{127}$ and to dummy word line $DWL_1$ while dummy cells $DC_{20}$, $DC_{21}$, ..., and $DC_{2,127}$ in a row are connected to the terminals of bit lines $\overline{BL_0}$, $\overline{BL_1}$, ..., and $\overline{BL_{127}}$ and to dummy word line $DWL_2$.

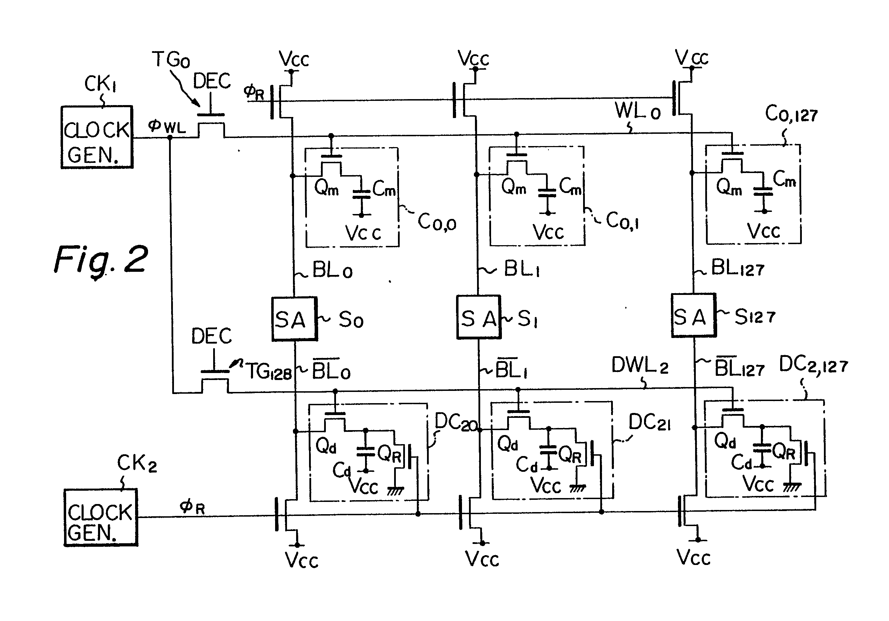

In Fig. 1, $\phi_{WL}$ is an operation clock signal for driving word lines $WL_0$, ..., $WL_{63}$, $WL_{64}$, ..., and $WL_{127}$ and dummy word lines $DWL_1$ and $DWL_2$. $\phi_R$ is a reset clock signal for resetting capacitor $Q_R$ (not shown in Fig. 1 but shown in Fig. 2) of each dummy cell and for precharging bit lines $BL_0$, $\overline{BL_0}$, $BL_1$, $\overline{BL_1}$, ..., $BL_{127}$ and $\overline{BL_{127}}$.

The selection of word lines $WL_0$, $WL_1$, ..., and $WL_{127}$ is carried out by word decoders DEC, and, simultaneously, the selection of dummy word lines $DWL_1$ and $DWL_2$ is also carried out by row decoders DEC. For example, when one of word lines $WL_0$ through $WL_{63}$ is selected, dummy word line $DWL_2$ is selected while when one of word lines $WL_{64}$ through $WL_{127}$ is selected, dummy word line $DWL_1$ is selected. Such selection is carried out by transfer gates $TG_{-1}$, $TG_0$, ..., $TG_{63}$, $TG_{64}$, ..., $TG_{127}$, and $TG_{128}$ which are switched on by word decoders DEC so as to transfer clock

signal $\phi_{WL}$. In more detail, word decoders DEC decode row address signals $A_0$, $\overline{A}_0$, $A_1$, $\overline{A}_1$, ..., $A_5$ and $\overline{A}_5$ so that one of transfer gates $TG_0$ through $TG_{127}$, that is, one of word lines $WL_0$ through $WL_{127}$, is selected, and, in addition, row decoders DEC decode row address signal $A_6$ or $\overline{A}_6$ so that one of transfer gates $TG_{-1}$ and $TG_{128}$, that is, one of dummy word lines $DWL_1$ and $DWL_2$, is selected.

In Fig. 2, which is a partial circuit diagram of the circuit of Fig. 1, word line $WL_0$ and dummy word line $DWL_2$ of Fig. 1 are illustrated in detail while the other word lines and dummy word line $DWL_1$ are omitted. That is, if word line $WL_0$ is selected, dummy word line $DWL_2$ on the opposite side regarding the sense amplifiers is always selected.

Each of memory cells $C_{00}$, $C_{01}$, ..., and $C_{0,127}$ comprises capacitor $C_m$ and transistor $Q_m$ while each of dummy cells $DC_{20}$, $DC_{21}$, ..., and $DC_{2,127}$ comprises capacitor $C_d$, transistor $Q_d$, and transistor $Q_R$. In this case, the capacity of each capacitor $C_d$ of the dummy memory cells is set to be about half the capacity of each capacitor $C_m$ of the memory cells. During the standby mode, reset clock generator $CK_2$ generates reset clock signal $\phi_R$ having a potential higher than $V_{cc}+V_{th}$, where $V_{th}$ is the common threshold voltage value of the enhancement transistors. As a result, capacitors $C_d$ of dummy cells $D_{20}$, $D_{21}$, ..., and $DC_{2,127}$ are discharged, and, simultaneously, bit lines $BL_0$, $\overline{BL_0}$, $BL_1$, $\overline{BL_1}$, ..., $BL_{127}$, and $\overline{BL_{127}}$ are precharged to potential $V_{cc}$. Next, during the selecting mode, operation clock generator $CK_1$ supplies clock signal $\phi_{WL}$ through on-state transfer gates $TG_0$ and $TG_{128}$ to word line $WL_0$ and dummy word line $DWL_2$, which means that word line $WL_0$ and dummy word line $DWL_2$ are selected. As a result, for example, when the potential of capacitor $C_m$ of memory cell $C_{00}$ is high (which corresponds to data "1", for example), the potential of bit line $BL_0$ does not decrease while when the potential of capacitor $C_m$ of memory cell $C_{00}$ is low (which corresponds to data "0"), the potential bit line $BL_0$ decreases. On the other hand, in dummy cell $DC_{20}$, since capacitor $C_d$ is charged, bit line $\overline{BL_0}$ decreases. In any case, since the capacity of capacitor $C_m$ is different from that of capacitor $C_d$, there is generated a difference in potential between bit lines $BL_0$ and $\overline{BL_0}$. Such difference in potential is sensed, that is, enlarged, by sense amplifier $S_0$, and then the difference is read out.

In Fig. 2, however, the load of operation clock generator $CK_1$ is dependent on not only the capacity of word line $WL_0$, the capacitor of the gates of transistors $Q_m$ of memory cells $C_{00}$, $C_{01}$, ..., and $C_{0,127}$, and the like, but also is dependent on the capacity of dummy word line $DWL_2$, the capacity of the gates of dummy cells $DC_{20}$, $DC_{21}$, ..., $DC_{2,127}$, and the like. Therefore, the load of operation clock generator $CK_1$ is large, and thereby the operation speed of the device is reduced.

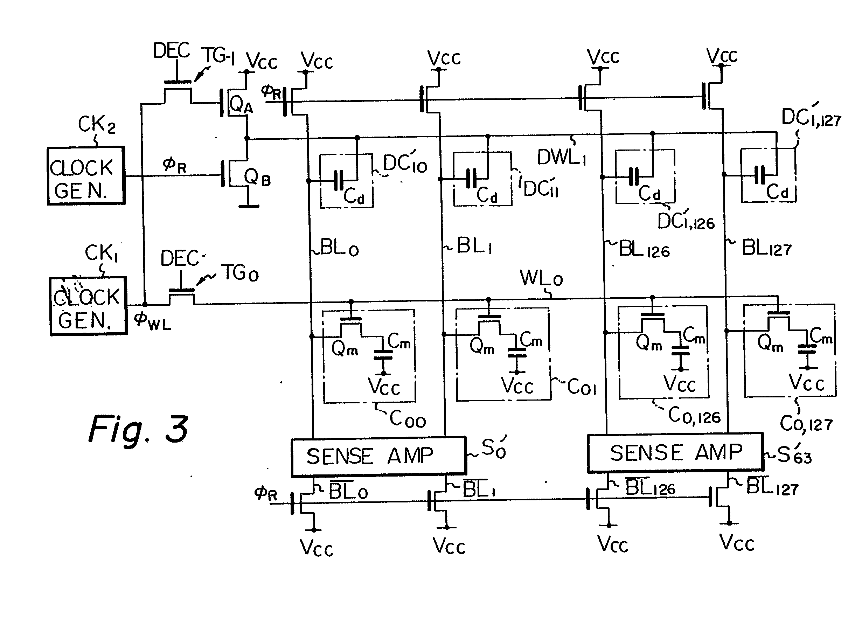

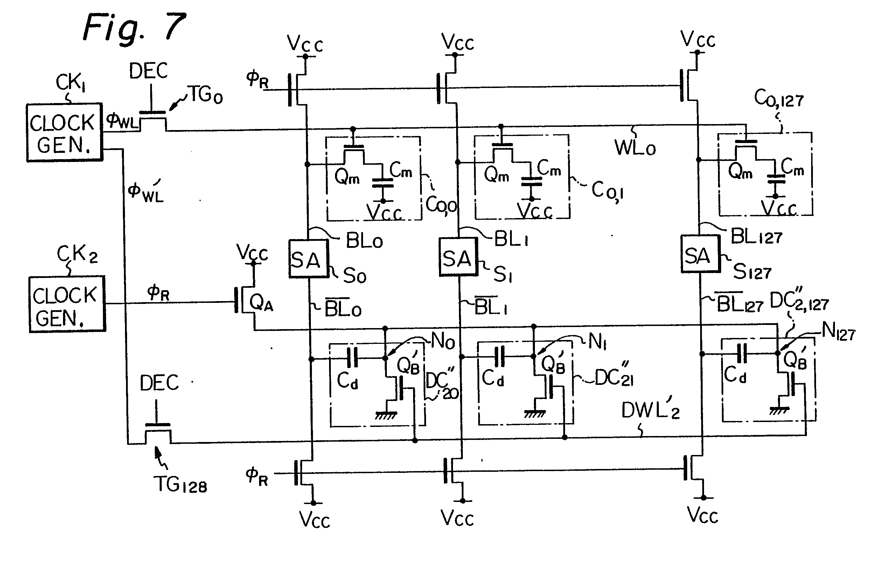

Figure 3 is a circuit diagram illustrating another prior art dynamic RAM device which is disclosed in Fig. 7 of the IEEE Journal of Solid-State Circuits, vol. SC-15, No. 2, pp. 184—189, Apr. 1980. In Fig. 3, word line $WL_0$ and dummy word line $DWL_1$ are illustrated in detail while the other word lines and dummy word line $DWL_2$ are omitted. That is, if word line $WL_0$ is selected, dummy word line $DWL_1$ on the same side regarding sense amplifiers $S_1'$, $S_2' \ldots$, and $S_{63}$, is alway selected.

Each of dummy cells $DC_{10}'$, $DC_{11}'$, . . ., and $DC_{1,127}'$ comprises only one capacitor $C_d$, thereby remarkably reducing the area occupied by the dummy cells in the chip as compared with the dummy memory cells of Fig. 2. $Q_A$ and $Q_B$ are charging and discharging transistors, respectively, for dummy word line $DWL_1$, that is, for capacitors $C_d$. Charging transistor $Q_A$ is clocked by clock signal $\phi_{WL}$ of operation clock generator $CK_1$ while discharging transistor $Q_B$ is clocked by clock signal $\phi_R$ of reset clock generator $CK_2$. Therefore, the load of operation clock generator $CK_1$ is dependent on the capacity of charging transistor $Q_A$ and the like in addition to the capacity of word line $WL_0$, the capacity of the gates of transistors $Q_m$ of memory cells $C_{00}$, $C_{01}$, . . ., and $C_{0,127}$, and the like, thereby reducing the load of operation clock generator $CK_1$.

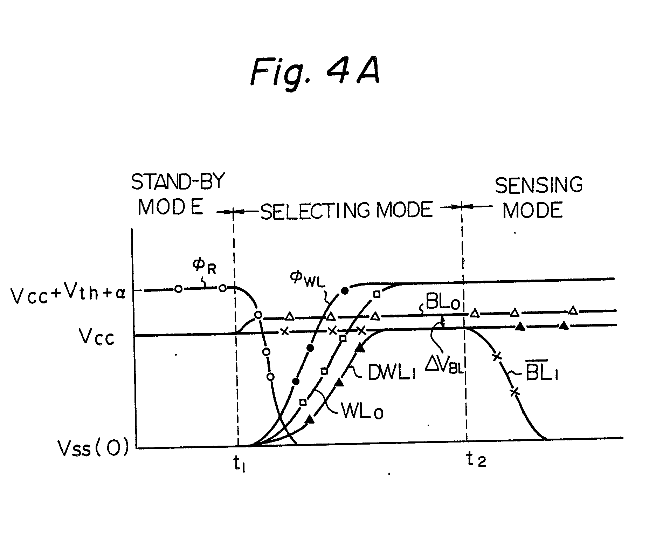

The operation of the circuit of Fig. 3 will now be explained with reference to Fig. 4A regarding only bit lines $BL_0$ and $\overline{BL}_1$ since sense amplifiers $S_0'$ responds to the pair of bit lines $BL_0$ and $\overline{BL}_1$. Assuming memory cell $C_{00}$ stores data "1", that is, that capacitor $C_m$ of memory cell $C_{00}$ is charged, during the standby mode, the reset clock signal is high $(V_{cc}+V_{th}+\alpha)$, discharging transistor $Q_B$ is turned on so that capacitors $C_d$ of dummy cells $DC_{10}'$, $DC_{11}'$, . . ., $DC_{1,126}'$, and $DC_{1,127}'$ are discharged, and, accordingly, the potential of dummy word line $DWL_1$ remains low ($V_{SS}$=ground level). Simultaneously, bit lines $BL_0$, $\overline{BL}_0$, $BL_1$, $\overline{BL}_1$, . . ., $BL_{126}$, $\overline{BL}_{126}$, $BL_{127}$, and $\overline{BL}_{127}$ are precharged to level $V_{cc}$. Next, during the selecting mode, the potential of clock signal $\phi_R$ is changed from level $V_{cc}+V_{th}+\alpha$ to level $V_{SS}$, and, in addition, the potential of clock signal $\phi_{WL}$ is changed from level $V_{SS}$ to level $V_{cc}+V_{th}+\alpha$. As a result, the potential of word line $WL_0$ selected by the decoder DEC is changed in common phase with the potential of clock signal $\phi_{WL}$. In addition, discharging transistor $Q_B$ is turned off while charging transistor $Q_A$ is turned on. As a result, the potential of the selected dummy word line $DWL_1$ is changed in common phase with the potential of clock signal $\phi_{WL}$. Simultaneously, the bit lines assume a floating state. In this case, since bit line $BL_0$ is connected to dummy word line $DWL_1$ by the capacitive coupling of capacitor $C_d$, the potential of bit line $BL_0$ is pulled up in proportion to the capacitance ratio of bit line $BL_0$ to dummy word line $DWL_1$. That is, the potential of dummy word line $DWL_1$ causes the potential of bit line $BL_0$ to be slightly positive relative to the potential of bit line $\overline{BL}_1$. Thus, a difference $\Delta V_{BL}$ in potential is generated between bit lines $BL_0$ and $\overline{BL}_1$, and, during the sensing mode, such difference is sensed by sense amplifier $S_0'$. As a result, the lower-side potential of bit line $\overline{BL}_1$ is decreased to $V_{SS}$.

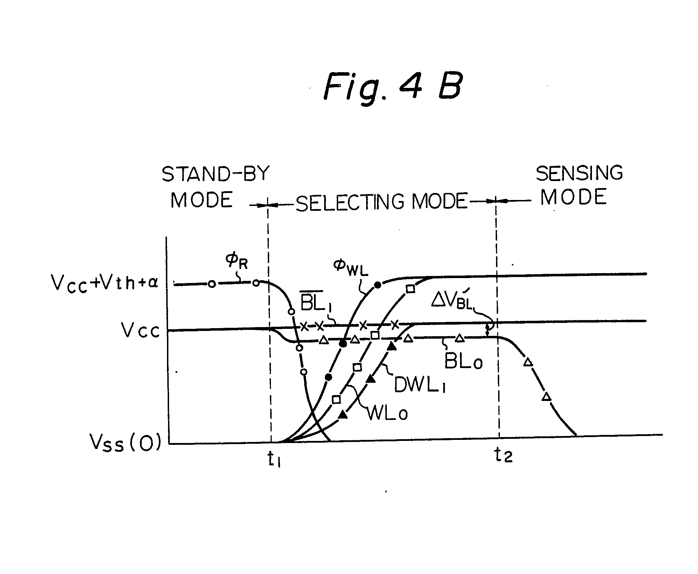

Similarly, assuming that memory cell $C_{00}$ stores data "0", that is, that capacitor $C_m$ of memory cell $C_{00}$ is discharged, the potential of dummy word line $DWL_1$ also causes the potential of bit line $BL_0$ to be high. However, current flows from bit line $BL_0$ into capacitor $C_m$ of memory cell $C_{00}$, and, accordingly, the potential of bit line $BL_0$ is pulled down in proportion to the capacitance ratio of capacitor $C_m$ of memory cell $C_{00}$ to bit line $BL_0$. Then, as illustrated in Fig. 4B, the potential of bit line $BL_0$ becomes slightly negative relative to the potential of bit line $\overline{BL}_1$. Thus, a difference $\Delta V_{BL}'$ in potential is generated between bit lines $BL_0$ and $\overline{BL}_1$, and, during the sensing mode, such difference $\Delta V_{BL}'$ in potential is sensed by sense amplifier $S_0'$. As a result, the lower-side potential of bit line $BL_0$ is decreased to $V_{SS}$.

In the dynamic RAM device of Fig. 3, however, in order to push up the potential of dummy word line $DWL_1$ to level $V_{CC}$, operation clock generator $CK_1$ must generate a potential higher than $V_{cc}+V_{th}$, that is, a potential of $V_{CC}+V_{th}+\alpha$, and, accordingly, operation clock generator $CK_1$ must incorporate a charge-pumping circuit or a bootstrap circuit which is not provided with a capability of driving quickly a heavy load including both dummy word line $DWL_1$ and word line $WL_0$. Therefore, the operation speed of row selection, that is, the access speed of the device, becomes low.

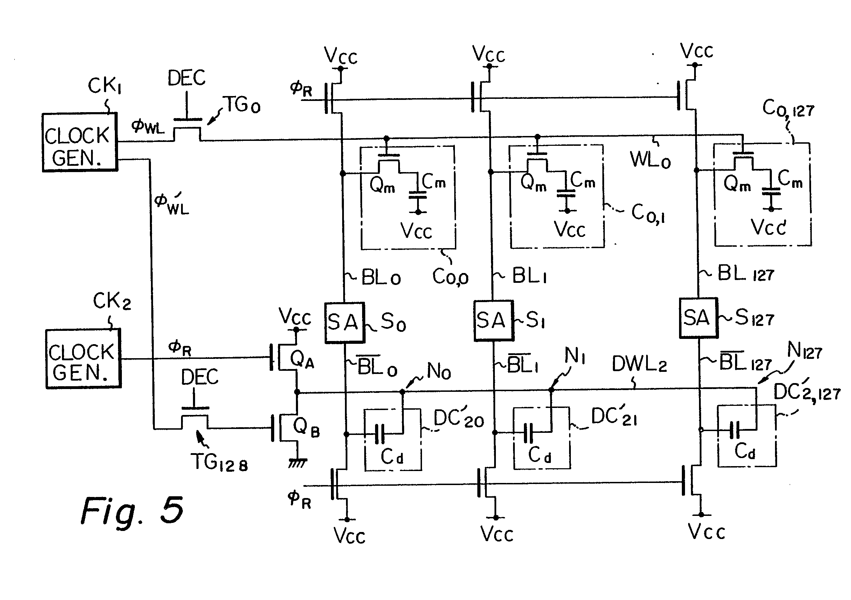

Figure 5 is a circuit diagram illustrating a first type of dynamic RAM device useful for explaining the present invention. In Fig. 5, the elements which are the same as those of Fig. 3 are denoted by the same reference numerals as in Fig. 3. As the figure shows, if word line $WL_0$ is selected, dummy word line $DWL_2$ on the opposite side regarding sense amplifiers $S_0$, $S_1$, . . ., and $S_{127}$ is selected. In addition, charging transistor $Q_A$ is connected to reset clock generating circuit $CK_2$ while discharging transistor $Q_B$ is connected through transfer gate $TG_{128}$ to operation clock signal generating circuit $CK_1$ which generates clock pulses $\phi_{WL}$ and $\phi_{WL}'$ in reciprocal phase with reset pulses $\phi_R$.

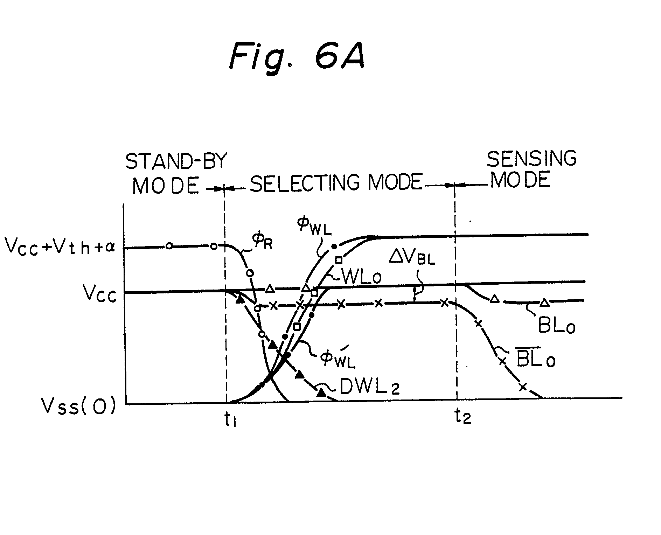

The operation of the circuit of Fig. 5 regarding only bit lines $BL_0$ and $\overline{BL}_0$ will now be explained with reference to Fig. 6A. Assuming that memory cell $C_{00}$ stores data "1", that is, that capacitor $C_m$ of memory cell $C_{00}$ is charged, during the standby mode, the reset clock signal $\phi_R$ is high $(V_{cc}+V_{th}+\alpha)$, charging transistor $Q_A$ is turned on so that capacitors $C_d$ of dummy cells $DC_{20}'$, $DC_{21}'$, . . ., $DC_{2,126}'$, and $DC_{2,127}'$ are charged, and, accordingly, the potential of dummy word line $DWL_2$ remains high ($V_{cc}$). Simultaneously, bit lines $BL_0$, $\overline{BL}_0$, $BL_1$, $\overline{BL}_1$, . . ., $BL_{126}$, $\overline{BL}_{126}$, $BL_{127}$, and $\overline{BL}_{127}$ are precharged to level $V_{cc}$. Next, during the selecting mode, the potential of clock signal $\phi_R$ is changed from level $V_{cc}+V_{th}+\alpha$ to level $V_{SS}$, and, contrary to this, the potential of clock signal $\phi_{WL}$ is changed from level $V_{SS}$ to level $V_{cc}+V_{th}+\alpha$. As a result, the potential of a selected word line $WL_0$ is changed in response to the potential of clock signal $\phi_{WL}$. When clock signal $\phi_{WL}$ is changed, clock generator $CK_1$ simultaneously generates clock signal $\phi_{WL}'$ which is changed from $V_{SS}$ to $V_{cc}$

in common phase with clock signal $\phi_{WL}$. Thus, charging transistor $Q_A$ is turned off while discharging transistor $Q_B$ is turned on. As a result, the potential of dummy word line $DWL_2$ is changed in opposite phase to the potential of clock signal $\phi_{WL}'$. Simultaneously, the bit lines assume a floating state. In this case, since bit line $\overline{BL_0}$ is connected to dummy word line $DWL_2$ by the capacitive coupling of capacitors $C_d$, the potential of bit line $\overline{BL_0}$ is pulled down by an amount in proportion to the capacitance ratio of dummy cell capacitor $C_d$ to bit line $\overline{BL_0}$. That is, the potential of dummy word line $DWL_1$ pulls down the potential of bit line $\overline{BL_0}$ so that it is slightly negative relative to the potential of bit line $BL_0$. Thus, a difference $\Delta V_{BL}$ in potential is generated between bit lines $BL_0$ and $\overline{BL_0}$, and, during the sensing mode, such difference is sensed by sense amplifier $S_0$. As a result, the lower-side potential of bit line $\overline{BL_0}$ is decreased to $V_{SS}$.

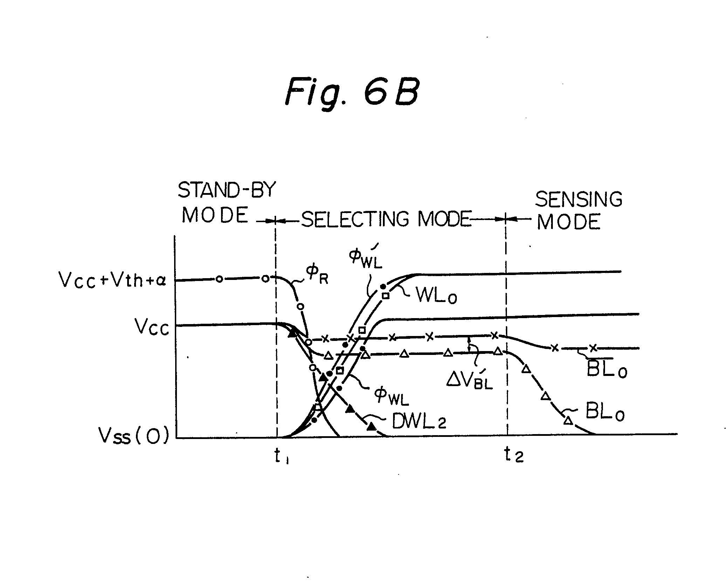

Similarly, assuming that memory cell $C_{00}$ stores data "0", that is, that capacitor $C_m$ of memory cell $C_{00}$ is discharged, the potential of dummy word line $DWL_2$ also pulls down the potential of bit line $\overline{BL_0}$. However, current flows from bit line $BL_0$ into capacitor $C_m$ of memory cell $C_{00}$ and, accordingly, the potential of bit line $BL_0$ is also pulled down by the capacity ratio of capacitor $C_m$ of memory cell $C_{00}$ to bit line $BL_0$. Dummy cell capacitor $C_d$ is designed to have about a half of the capacitance of one memory cell capacitor $C_m$. Then, as illustrated in Fig. 6B, the potential of bit line $BL_0$ becomes slightly negative relative to the potential of bit line $\overline{BL_0}$. Thus, a difference in potential $\Delta V_{BL}'$ is generated between bit lines $BL_0$ and $\overline{BL_0}$, and, during the sensing mode, such difference in potential is sensed by sense amplifier $S_0$. As a result, the lower-side potential of bit line $BL_0$ is decreased to $V_{SS}$.

In the dynamic RAM device of Fig. 5, operation clock generator $CK_1$ generates clock signals $\phi_{WL}$ having level $V_{cc}+V_{th}+\alpha$ and $\phi_{WL}'$ having level $V_{cc}$. However, it should be noted that the load driven by the clock signal $\phi_{WL}$ which requires a high level $V_{cc}+V_{th}+\alpha$ is reduced. As stated above, a clock signal having a level higher than $V_{cc}$ is generated by a charge-pumping circuit, bootstrap circuit, or the like which usually has only an ability to drive a small load. Therefore, if the load which requires clock signal having level higher than $V_{cc}$ is small, the operation speed of operation clock generator $CK_1$ becomes high. As a result, the access speed of the device becomes high.

Not that generally in a memory device, the highest priority of design is to reduce the access time. Therefore, although reset clock generator $CK_2$ incorporates a charge-pumping circuit or a bootstrap circuit for generating a potential higher than $V_{cc}$, this is not disadvantageous since the reset operation does not affect the access speed.

Figure 7 is a circuit diagram illustrating a second type of dynamic RAM useful for explaining the present invention. In Fig. 7, each of dummy cells $DC_{20}'''$, $DC_{21}'''$, ..., and $DC_{2,127}'''$ comprises discharging transistor $Q_B'$, for dis-

charging capacitor $C_d$, instead of discharging transistor $Q_B$ of Fig. 5. In this case, discharging transistor $Q_B'$ are smaller than discharging transistor $Q_B$ of Fig. 5. However, the operation of the circuit of Fig. 7 is substantially the same as that of the circuit of Fig. 5. Note that, in this case, dummy word line $DWL_2'$ is not directly connected to capacitors $C_d$ of dummy cells $DC_{20}''$, $DC_{21}''$, ..., and $DC_{2,127}''$. In addition, the potential at node $N_0$, $N_1$, ..., or $N_{127}$ of Fig. 7 corresponds to the potential of dummy word line $DWL_2$ of Fig. 5.

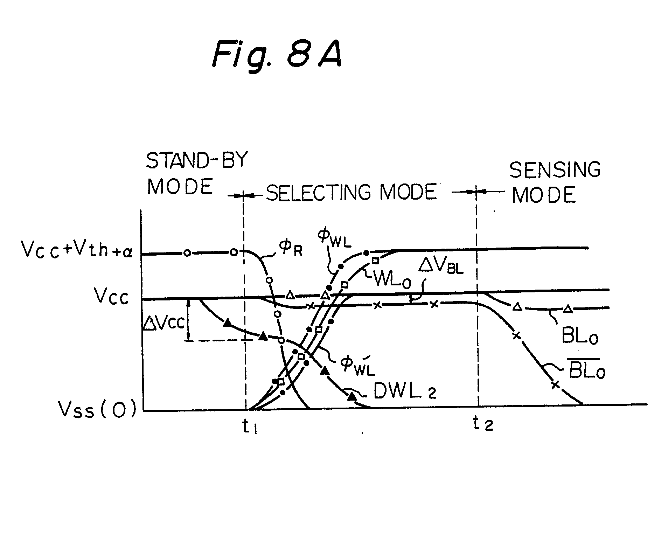

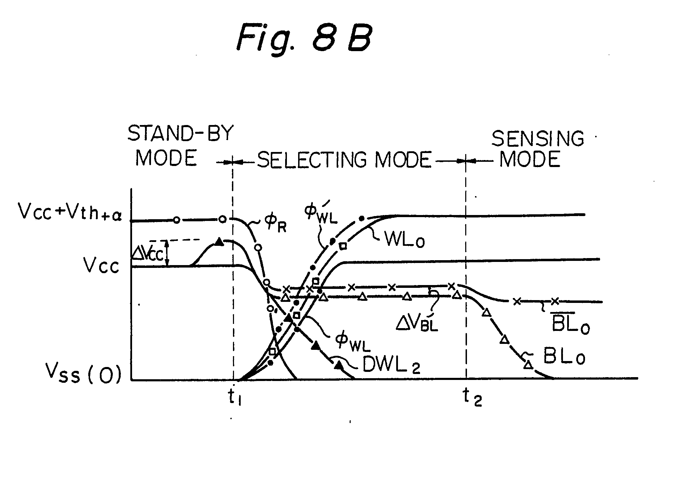

Figures 8A and 8B are also timing diagrams of the signals appearing in the circuit of Fig. 5 (or 7). In Figs. 8A and 8B, it is assumed that the potential of the power supply $V_{cc}$ fluctuates at the transition from the standby mode to the selecting mode. That is, since charging transistor $Q_A$ is relatively large, the potential of dummy word line $DWL_2$ rapidly follows the fluctuation of the power supply potential $V_{cc}$. Contrary to this, since the bit lines have a large capacitance and, in addition, the precharging transistors are relatively small so as to limit current therethrough, the potential of the bit lines responds very slowly to fluctuation of the power supply voltage $V_{cc}$.

In Fig. 8A, which corresponds to Fig. 6A, the power supply potential is decreased from $V_{cc}$ to $V_{cc}-\Delta V_{cc}$. In this case, the potential of bit line $\overline{BL_0}$ is not as decreased as in Fig. 6A. That is, in the case of reading data "1", the difference $\Delta V_{BL}$ in potential becomes small. Consequently, the sensing speed is reduced, and an erroneous read operation may result. Contrary to this, in Fig. 8B, which corresponds to Fig. 6B, the power supply potential is increased from $V_{cc}$ to $V_{cc}+\Delta V_{cc}$. In this case, the potential of bit line $\overline{BL_0}$ is decreased greatly as compared with Fig. 6B. That is, in the case of reading data "0", the difference $\Delta V_{BL}'$ in potential also becomes small. Consequently, the sensing speed is reduced, and an erroneous read operation may result.

In order to avoid fluctuation of the potential of the bit lines due to fluctuation of a power supply potential, according to the present invention, capacitor $C_d$ of the dummy cell can also be charged by using the potential of the corresponding bit line.

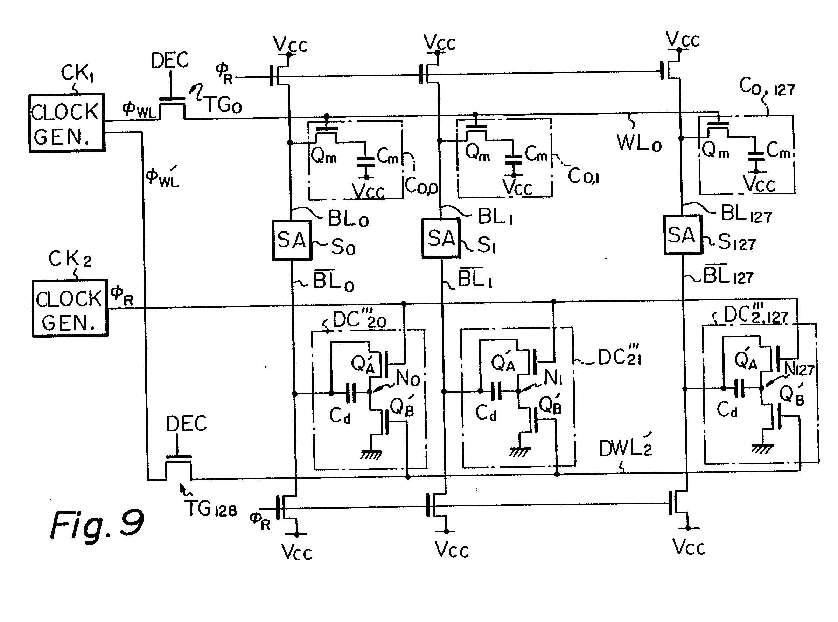

Figure 9 is a circuit diagram illustrating an embodiment of the dynamic RAM device according to the present invention. In Fig. 9, each of dummy cells $DC_{20}''''$, $DC_{21}''''$, ..., and $DC_{2,127}''''$ comprises charging transistor $Q_A'$ instead of charging transistor $Q_A$ of Fig. 7. That is, charging transistor $Q_A'$ of dummy cell $DC_{20}''''$ is connected between bit line $\overline{BL_0}$ and node $N_0$. Therefore, during the standby mode, even when power supply potential $V_{cc}$ fluctuates rapidly, the potential at node $N_0$, $N_1$, ..., or $N_{127}$ of capacitors $C_d$ remains stable since the potential at node $N_0$, $N_1$, ..., or $N_{127}$ follows the potential of bit line $\overline{BL_0}$, $\overline{BL_1}$, ..., or $\overline{BL_{127}}$, which potential does not fluctuate so much. Therefore, the above-mentioned unfavorable difference in potential, which reduces the sensing speed and may result in an erroneous read operation is not generated.

As explained hereinbefore, the dynamic RAM device according to the present invention is advantageous, as compared with the prior art as illustrated in Fig. 3, in that the access speed is high since it is unnecessary that the operation clock generator $CK_1$ drives a heavy load requiring a potential higher than $V_{CC}$ in the selecting operation.

## Claims

1. A dynamic random access memory device comprising:

first and second power supplies ($V_{SS}$, $V_{CC}$), the potential of said first power supply ($V_{SS}$) being lower than that of said second power supply ($V_{CC}$);

a plurality of word lines ($WL_0 ... WL_{127}$) selectively driven by a first clock signal ($\phi_{WL}$);

a plurality of pairs of bit lines ($BL_0$, $\overline{BL_0} ... BL_{127}$, $\overline{BL_{127}}$) precharged by said second power supply in response to a third clock signal ($\phi_R$);

a plurality of sense amplifiers ($S_0 ... S_{127}$), each sense amplifier being arranged between one pair of said pairs of bit lines, for sensing the difference in potential between said pairs of bit lines;

a plurality of one-transistor, one-capacitor-type memory cells ($C_{0,0} ... C_{127,127}$) in rows and columns, each memory cell being connected to one of said word lines and to one of said bit lines;

a plurality of dummy cells ($DC_{20}', ... DC2,12_7'$), each dummy cell comprising a capacitor ($C_d$) and a connection node ($N_0 ... N_{127}$), said capacitor having an electrode connected to one of said bit lines and another electrode connected to one of said connection nodes; characterised by

a first clock generator ($CK_1$) for generating said first clock signal ($\phi_{WL}$) with a potential higher than the potential of the second power supply ($V_{CC}$) and a second clock signal ($\phi_{WL}'$) with a potential lower than or equal to the potential of said second power supply ($V_{CC}$);

a second clock generator ($CK_2$) for generating said third clock signal ($\phi_R$) with a potential higher than the potential of said second power supply ($V_{CC}$) alternately with the first and second clock signals ($\phi_{WL}$, $\phi_{WL}'$);

charging means comprising a plurality of transistors ($Q_A'$), each transistor being incorporated into one of said dummy cells ($DC_{20}''' ... DC_{2,127}'''$) and having a drain connected to said respective bit line, a source connected to one of said connection nodes of said dummy cells, and a gate for receiving said third clock signal ($\phi_R$) so as to be driven thereby to charge the connection nodes of each of said dummy cells to the potential of said second power supply ($V_{CC}$); and

at least one discharging means comprising at least one transistor ($Q_B$, $Q_B'$), each discharging means being connected to each of said connection nodes of said dummy cells respectively and driven by said second clock signal ($\phi_{WL}'$), for discharging the connection nodes of each of said dummy cells to the potential of said first power supply ($V_{SS}$).

2. A device as set forth in claim 1, wherein said discharging means comprises a transistor ($Q_B$) having a drain connected to said connection nodes of said dummy cells ($DC_{20}' ... DC_{2,127}'$), a gate for receiving said second clock signal ($\phi_{WL}'$), and a source connected to said first power supply ($V_{SS}$).

3. A device as set forth in claim 1, wherein said discharging means comprises a plurality of transistors ($Q_B'$), each transistor being incorporated into one of said dummy cells ($DC_{20}'' ... DC_{2,127}''$) and having a drain connected to one of said connection nodes of said dummy cells, a gate for receiving said second clock signal ($\phi_{WL}'$), and a source connected to said first power supply ($V_{SS}$).

## Patentansprüche

1. Dynamische Speichervorrichtung mit wahlfreiem Zugriff, mit:

ersten und zweiten Energieversorgungen ($V_{SS}$, $V_{CC}$), wobei das Potential der genannten ersten Energieversorgung ($V_{SS}$) niedriger als das der genannten zweiten Energieversorgung ($V_{CC}$) ist;

einer Vielzahl von Wortleitungen ($WL_0 ... WL_{127}$), die wahlweise von einem ersten Taktsignal ($\phi_{WL}$) getrieben werden;

eine Vielzahl von Paaren von Bitleitungen ($BL_0$, $\overline{BL_0} ... \overline{BL_{127}}$), die durch die genannte zweite Energieversorgung in Abhängigkeit von einem dritten Taktsignal ($\phi_R$) vorgeladen werden;

einer Vielzahl von Leseverstärkern ($S_0 ... S_{127}$), von denen jeder Leseverstärker zwischen einem Paar der genannten Paare von Bitleitungen angeordnet ist, um die Potentialdifferenz zwischen den genannten Paaren von Bitleitungen zu lesen;

einer Vielzahl von ein-Transistor-, ein-Kondensator-Typ-Speicherzellen ($C_{0,0} ... C_{127,127}$) in Reihen und Spalten, von denen jede Speicherzelle mit einer der genannten Wortleitungen und einer der genannten Bitleitungen verbunden ist;

einer Vielzahl von blinden Zelle ($DC'_{20}, ... DC'_{2,127}$), von denen jede Blinde Zelle einen Kondensator ($C_d$) und einen Verbindungsknoten ($N_0 ... N_{127}$) umfaßt, welcher genannte Kondensator eine Elektrode hat, die mit einer der genannten Bitleitungen verbunden ist, und eine andere Elektrode, die mit einem der genannten Verbindungsknoten verbunden ist, gekennzeichnet durch

einen ersten Taktgenerator ($CK_1$) zum Generieren des genannten ersten Taktsignals ($\phi_{WL}$) mit einem Potential, das höher als das Potential der zweiten Energieversorgung ($V_{CC}$) ist, und eines zweiten Taktsignals ($\phi_{WL}'$) mit einem Potential, das niedriger als oder gleich dem Potential der genannten zweiten Energieversorgung ($V_{CC}$) ist;

einem zweiten Taktgenerator ($CK_2$) zum Generieren des genannten dritten Taktsignals ($\phi_R$) mit einem Potential, das höher als das Potential der genannten zweiten Energieversorgung ($V_{CC}$) ist, alternativ mit den ersten und zweiten Taktsignalen ($\phi_{WL}$, $\phi'_{WL}$);

Ladeeinrichtungen, die eine Vielzahl von Transistoren ($Q_A'$) umfassen, von denen jeder Transistor in einer der blinden Zellen ($DC_{20}'''\dots DC_{2,127}'''$) inkorporiert ist und ein Drain, das mit der genannten entsprechenden Bitleitung verbunden ist, eine Source, die mit einem der genannten Verbindungsknoten der genannten blinden Zellen verbunden ist, und ein Gate hat, um das genannte dritte Taktsignal ($\phi_R$) zu empfangen, um so getrieben zu werden, um dadurch die Verbindungsknoten von den genannten blinden Zellen mit dem Potential der genannten zweiten Energieversorgung ($V_{CC}$) zu verbinden; und

wenigstens einer Entladeeinrichtung, die wenigstens einen Transistor ($Q_B, Q_B'$) umfaßt, von denen jede Entladeeinrichtung mit jedem der genannten Verbindungsknoten der jeweiligen genannten blinden Zellen verbunden ist und durch das genannte zweite Taktsignal ($\phi_{WL}'$) getrieben wird, um die Verbindungsknoten von jeder der genannten blinden Zellen auf das Potential der genannten ersten Energieversorgung ($V_{SS}$) zu entladen.

2. Vorrichtung nach Anspruch 1, bei der die genannte Entladeeinrichtung einen Transistor ($Q_B$) umfaßt, der ein Drain hat, das mit den genannten Verbindungsknoten von den genannten blinden Zellen ($DC_{20}'\dots DC_{2,127}'$) verbunden ist, ein Gate zum Empfangen des genannten zweiten Taktsignals ($\phi_{WL}'$) und eine Source, die mit der genannten ersten Energieversorgung ($V_{SS}$) verbunden ist.

3. Vorrichtung nach Anspruch 1, bei der die genannte Entladeeinrichtung eine Vielzahl von Transistoren ($Q_B'$) umfaßt, von denen jeder Transistor in eine der genannten blinden Zellen ($DC_{20}''\dots DC_{2,127}''$) inkorporiert ist und ein Drain hat, das mit einem der genannten Verbindungsknoten der genannten blinden Zellen verbunden ist, ein Gate zum Empfangen des genannten zweiten Taktsignals ($\phi_{WL}'$) und eine Source, die mit der genannten ersten Energieversorgung ($V_{SS}$) verbunden ist.

**Revendications**

1. Dispositif de mémoire à accès sélectif dynamique comprenant:

des première et deuxième sources d'alimentation ($V_{SS}, V_{CC}$), le potentiel de la première source d'alimentation ($V_{SS}$) étant inférieur à celui de la deuxième source d'alimentation ($V_{CC}$);

un ensemble de fils de mot ($WL_0 \dots WL_{127}$) excités sélectivement par un premier signal d'horloge ($\phi_{WL}$);

un ensemble de paires de fils de bits ($BL_0, \overline{BL}_0, \dots, BL_{127}, \overline{BL}_{127}$) préchargées par la deuxième source d'alimentation en réponse à un troisième signal d'horloge ($\phi_R$);

un ensemble d'amplificateurs de détection ($S_0, \dots, S_{127}$), chaque amplificateur de détection étant disposé entre une paire des paires de fils de bit, pour détecter la différence de potentiel entre les paires de fils de bit;

un ensemble de cellules de mémoire du type à un transistor et un condensateur ($C_{0,0}, \dots, C_{127,127}$) en lignes et en colonnes, chaque cellule de mémoire étant connectée à un des fils de mot et à un des fils de bit;

un ensemble de cellules fictives ($DC_{20}', \dots, DC_{2,127}'$), chaque cellule fictive comprenant un condensateur ($C_d$) et un noeud de connexion ($N_0, \dots, N_{127}$), le condensateur ayant une électrode connectée à un des fils de bit et une autre électrode connectée à un des noeuds de connexion;

caractérisé par

un premier générateur de signaux d'horloge ($CK_1$) pour engendrer le premier signal d'horloge ($\phi_{WL}$) avec un potentiel supérieur au potentiel de la deuxième source d'alimentation ($V_{CC}$) et un deuxième signal d'horloge ($\phi_{WL}'$) avec un potentiel inférieur ou égal au potentiel de la deuxième source d'alimentation ($V_{CC}$);

un deuxième générateur de signaux d'horloge ($CK_2$) pour engendrer le troisième signal d'horloge ($\phi_R$) avec un potentiel supérieur au potentiel de la deuxième source d'alimentation ($V_{CC}$) alternativement avec les premier et deuxième signaux d'horloge ($\phi_{WL}, \phi_{WL}'$);

un moyen de charge comprenant un ensemble de transistors ($Q_A'$), chaque transistor étant incorporé dans une des cellules fictives ($DC_{20}''', \dots, DC_{2,127}'''$) et comportant un drain connecté au fil de bit respectif, une source connectée à un des noeuds de connexion des cellules fictives, et une grille pour recevoir le troisième signal d'horloge ($\phi_R$) de manière à ce qu'il soit ainsi commandé pour charger les noeuds de connexion de chacune des cellules fictives au potentiel de la deuxième source d'alimentation ($V_{CC}$); et

au moins un moyen de décharge comprenant au moins un transistor ($Q_B, Q_B'$), chaque moyen de décharge étant connecté à chacun des noeuds de connexion des cellules fictives respectivement et commandé par le deuxième signal d'horloge ($\phi_{WL}'$), pour décharger les noeuds de connexion de chacune des cellules fictives au potentiel de la première source d'alimentation ($V_{SS}$).

2. Dispositif selon la revendication 1, dans lequel le moyen de décharge comprend un transistor ($Q_B$) comportant un drain connecté aux noeuds de connexion des cellules fictives ($DC_{20}', \dots, DC_{2,127}'$), une grille pour recevoir le deuxième signal d'horloge ($\phi_{WL}'$), et une source connectée à la première source d'alimentation ($V_{SS}$).

3. Dispositif selon la revendication 1, dans lequel le moyen de décharge comprend un ensemble de transistors ($Q_B'$), chaque transistor étant incorporé dans une des cellules fictives ($DC_{20}'', \dots, DC_{2,127}''$) et comportant un drain connecté à un des noeuds de connexion des cellules fictives, une grille pour recevoir le deuxième signal d'horloge ($\phi_{WL}'$), et une source connectée à la première source d'alimentation ($V_{SS}$).

Fig. 1

Fig. 2

*Fig. 3*

# Fig. 4A

# Fig. 4 B

Fig. 5

# Fig. 6A

# *Fig. 6 B*

Fig. 7

## Fig. 8A

# Fig. 8 B

Fig. 9